# EUROPEAN PATENT APPLICATION

(11) **EP 4 775 620 A1**
(43) Date of publication of application: **15.07.2026**
(21) Application number: 24862649.1
(22) Date of filing: 26.08.2024
(51) Int. Cl.: C08J 5/24, B32B 15/08, C08K 7/14, C08L 79/00, H01L 23/14, H01L 23/29, H01L 23/31, H05K 1/03

(54) **PREPREG, LAMINATE, PRINTED WIRING BOARD, AND SEMICONDUCTOR PACKAGE**

(30) Priority: 08.09.2023 JP 2023146372
(71) Applicant: Resonac Corporation, Tokyo 105-7325 (JP)
(72) Inventor: IGUCHI, Keitaro, Tokyo 105-7325 (JP); SATO, Tsutomu, Tokyo 105-7325 (JP); HIYAMA, Shun, Tokyo 105-7325 (JP); SHIMADA, Mami, Tokyo 105-7325 (JP)
(74) Representative: Hoffmann Eitle
(86) International application number: PCT/JP2024/030331
(87) International publication number: WO 2025/052997

(57) **Abstract**

Disclosed are: a prepreg which contains a resin composition containing a siloxane-modified maleimide resin and a fiber substrate containing glass fibers having an Al₂O₃ content of 20% by mass or more; and a laminated plate, a printed wiring board, and a semiconductor package which use the prepreg.

## Description

### Technical Field

The present embodiment relates to a prepreg, a laminated plate, a printed wiring board, and a semiconductor package.

### Background Art

In recent years, in the field of semiconductor packages, the wiring density has been increased and the degree of integration has been increased, and accordingly, printed wiring boards are required to have higher reliability than before. In order to improve the reliability of a printed wiring board, improvement of heat resistance, low thermal expansion property, adhesiveness to a conductor, and the like are required for a substrate for a printed wiring board.

PTL 1 discloses a thermosetting resin composition containing an amino-modified siloxane compound (A) having at least one primary amino group in one molecule and a maleimide compound (B) having at least two N-substituted maleimide groups in one molecule, as a thermosetting resin composition exhibiting excellent low curing shrinkage property, low thermal expansion property, good adhesiveness to a copper foil, and high elastic modulus.

### Citation List

### Patent Literature

PTL 1:JP 2016-030757 A

### Summary of Invention

### Technical Problem

In a multilayer printed wiring board, a through hole for connecting an inner layer copper and an outer layer copper may be formed in an insulating layer.

For example, when a conductor circuit is formed by a semi-additive process (SAP), after a through hole is formed in an insulating layer, a desmearing treatment is performed to remove smears present at the bottom of the through hole, and then an electroless copper plating layer called a seed layer is formed on the insulating layer and in the through hole. Further, after a resist pattern is formed on the seed layer, a circuit pattern is formed by electrolytic copper plating in a portion where the resist pattern is not present, and then the resist pattern and the seed layer in an unnecessary portion are removed to form a conductor circuit.

As described above, in recent years, the wiring density of the printed wiring board has been remarkably increased, and accordingly, the through holes have been reduced in diameter. According to the study of the present inventors, it has been found that it is difficult to obtain good plating property in the through hole because the plating liquid is hard to flow into the through hole having a reduced diameter. In order to obtain good plating property in the through hole having a reduced diameter, the insulating layer is required to have high wettability to water so that the plating liquid easily flows into the through hole, but the wettability to water of the conventional material is not sufficient.

In view of such a current situation, an object of the present embodiment is to provide a prepreg of which a cured product has excellent wettability to water, and a laminated plate, a printed wiring board, and a semiconductor package using the prepreg.

### Solution to Problem

In order to solve the above problems, the present inventors have conducted intensive studies, and as a result, have found that the above problems can be solved by the following present embodiment, and have completed the present embodiment.

That is, the present embodiment relates to the following [1] to [8].
[1] A prepreg containing: a resin composition containing a siloxane-modified maleimide resin; and a fiber substrate containing glass fibers having an Al₂O₃ content of 20% by mass or more.
[2] The prepreg according to the item [1], in which the siloxane-modified maleimide resin has a structure derived from a maleimide resin having one or more N-substituted maleimide groups and a structure derived from a siloxane compound having two primary amino groups.
[3] The prepreg according to the item [1] or [2], in which the glass fibers further contain SiO₂, and a total content of the Al₂O₃ and the SiO₂ in the glass fibers is 70% by mass or more.
[4] The prepreg according to any one of the items [1] to [3], in which a content of the resin composition in the prepreg is 30 to 90% by mass.
[5] A laminated plate including a cured product of the prepreg according to any one of the items [1] to [4], and a metal foil.
[6] A printed wiring board including a cured product of the prepreg according to any one of the items [1] to [5].
[7] A semiconductor package including the printed wiring board according to the item [6], and a semiconductor element.
[8] A method for producing a printed wiring board, including forming a through hole in a cured product of the prepreg according to any one of the items [1] to [5], and then forming a conductor layer in the through hole by a plating method.

### Advantageous Effects of Invention

According to the present embodiment, it is possible to provide a prepreg of which a cured product has excellent wettability to water, and a laminated plate, a printed wiring board, and a semiconductor package using the prepreg.

### Description of Embodiments

In the description herein, a numerical range indicated by using "to" indicates a range including numerical values described before and after "to" as a minimum value and a maximum value, respectively.

For example, the expression of a numerical range "X to Y" (X and Y are real numbers) means a numerical range in which the range is equal to or greater than X and equal to or less than Y. Further, the description of "X or more" in the description herein means X and a numerical value exceeding X. Furthermore, the description of "Y or less" in the description herein means Y and a numerical value less than Y.

The lower limit value and the upper limit value of the numerical range described in the description herein can be arbitrarily combined with the lower limit value or the upper limit value of another numerical range, respectively.

In the numerical range described in the description herein, the lower limit value or the upper limit value of the numerical range may be replaced with a value shown in Examples.

Each component and material exemplified in the description herein may be used alone or may be used in combination of two or more kinds thereof, unless otherwise specified.

In the description herein, when a plurality of substances corresponding to each component are present in a resin composition, the content of each component in the resin composition means the total amount of the plurality of substances present in the resin composition, unless otherwise specified.

The expression "containing XX" described in the description herein, when XX can react, includes both the case where XX may be contained in a reacted state, and the case where XX may be simply contained.

In the description herein, the "solid content" means a component other than a solvent, and a component that is liquid at 25°C is also regarded as a solid content.

The expression "containing XX" described in the description herein, when XX can react, includes both the case where XX may be contained in a reacted state, and the case where XX may be simply contained.

The weight-average molecular weight (Mw) in the description herein means a value measured by gel permeation chromatography (GPC) in terms of polystyrene. To be specific, the weight-average molecular weight (Mw) in the description herein can be measured by a method described in Examples.

In the description herein, the "semi-cured product" has the same meaning as a resin composition in a B-stage state in JIS K 6800 (2006), and the "cured product" has the same meaning as a resin composition in a C-stage state in JIS K 6800 (2006).

The action mechanism described in the description herein is a conjecture, and does not limit the mechanism by which the effect of the present embodiment is exhibited.

An aspect in which the matters described in the description herein are arbitrarily combined is also included in the present embodiment.

### [Prepreg]

The prepreg of the present embodiment is a prepreg containing: a resin composition containing a siloxane-modified maleimide resin; and a fiber substrate containing glass fibers having an Al₂O₃ content of 20% by mass or more.

### <Resin Composition>

The resin composition contained in the prepreg of the present embodiment contains a siloxane-modified maleimide resin.

Hereinafter, the siloxane-modified maleimide resin may be referred to as "(A) siloxane-modified maleimide resin" or "component (A)".

In the description herein, each component may be abbreviated as component (A), component (B), or the like, and other components may be abbreviated in the same manner.

Hereinafter, each component contained in the resin composition will be described in order.

### ((A) Siloxane-Modified Maleimide Resin)

The component (A) is not particularly limited as long as it is obtained by modifying a maleimide resin with a siloxane compound.

The siloxane-modified maleimide resin (A) may be used alone or may be used in combination of two or more kinds thereof.

The siloxane-modified maleimide resin (A) preferably has a structure derived from a maleimide resin having one or more N-substituted maleimide groups [hereinafter sometimes referred to as "maleimide resin (AX)" or "component (AX)"] and a structure derived from a siloxane compound having two primary amino groups [hereinafter sometimes referred to as "siloxane diamine"].

### <<Structure Derived from Maleimide Resin (AX)>>

Examples of the structure derived from the maleimide resin (AX) include a structure formed by a Michael addition reaction between at least one N-substituted maleimide group of the N-substituted maleimide groups of the maleimide resin (AX) and the primary amino group of the siloxane diamine.

The structure derived from the maleimide resin (AX) contained in the siloxane-modified maleimide resin (A) may be one kind alone, or may be two or more kinds.

The content of the structure derived from the maleimide resin (AX) in the siloxane-modified maleimide resin (A) is preferably 5 to 95% by mass, more preferably 30 to 93% by mass, and still more preferably 60 to 90% by mass, from the viewpoint of heat resistance.

### - Maleimide Resin (AX) -

The maleimide resin (AX) is preferably an aromatic maleimide resin having two or more N-substituted maleimide groups, and more preferably an aromatic bismaleimide resin having two N-substituted maleimide groups, from the viewpoints of adhesiveness to a conductor and heat resistance.

In the description herein, the "aromatic maleimide resin" means a compound having an N-substituted maleimide group directly bonded to an aromatic ring. Further, in the description herein, the "aromatic bismaleimide resin" means a compound having two N-substituted maleimide groups directly bonded to an aromatic ring. Furthermore, in the description herein, the "aromatic polymaleimide resin" means a compound having three or more N-substituted maleimide groups directly bonded to an aromatic ring. In addition, in the description herein, the "aliphatic maleimide resin" means a compound having an N-substituted maleimide group directly bonded to an aliphatic hydrocarbon.

As the maleimide resin (AX), a maleimide resin represented by the following general formula (A-1) is preferable. 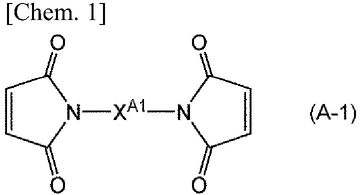 (In the formula, X^{A1} is a divalent organic group.)

Examples of the divalent organic group represented by X^{A1} in the general formula (A-1) include a divalent organic group represented by the following general formula (A-2), a divalent organic group represented by the following general formula (A-3), a divalent organic group represented by the following general formula (A-4), a divalent organic group represented by the following general formula (A-5), and a divalent organic group represented by the following general formula (A-6). 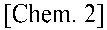 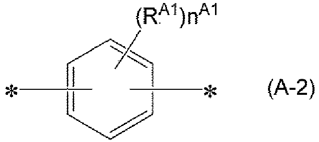 (In the formula, R^{A1} is an aliphatic hydrocarbon group having 1 to 5 carbon atoms or a halogen atom; n^{A1} is an integer of 0 to 4; and * represents a bonding site.)

Examples of the aliphatic hydrocarbon group having 1 to 5 carbon atoms represented by R^{A1} in the general formula (A-2) include an alkyl group having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms; and an alkynyl group having 2 to 5 carbon atoms. The aliphatic hydrocarbon group having 1 to 5 carbon atoms may be either linear or branched.

Examples of the halogen atom include a fluorine atom, a chlorine atom, a bromine atom, and an iodine atom.

When n^{A1} is an integer of 2 or more, a plurality of R^{A1}'s may be the same as or different from each other. 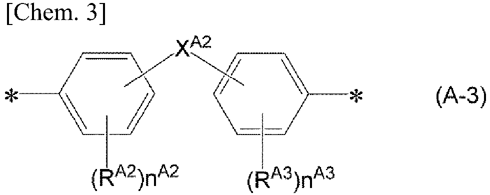 (In the formula, R^{A2} and R^{A3} are each independently an aliphatic hydrocarbon group having 1 to 5 carbon atoms or a halogen atom; X^{A2} is an alkylene group having 1 to 5 carbon atoms, an alkylidene group having 2 to 5 carbon atoms, an ether group, a sulfide group, a sulfonyl group, a carbonyloxy group, a keto group, a single bond, or a divalent organic group represented by the following general formula (A-3-1); n^{A2} and n^{A3} are each independently an integer of 0 to 4; and * represents a bonding site.)

Examples of the aliphatic hydrocarbon group having 1 to 5 carbon atoms and the halogen atom represented by R^{A2} and R^{A3} in the general formula (A-3) are the same as those described above for R^{A1}.

Examples of the alkylene group having 1 to 5 carbon atoms represented by X^{A2} in the general formula (A-3) include a methylene group, a 1,2-dimethylene group, a 1,3-trimethylene group, a 1,4-tetramethylene group, and a 1,5-pentamethylene group.

Examples of the alkylidene group having 2 to 5 carbon atoms represented by X^{A2} in the general formula (A-3) include an ethylidene group, a propylidene group, an isopropylidene group, a butylidene group, an isobutylidene group, a pentylidene group, and an isopentylidene group.

When n^{A2} or n^{A3} is an integer of 2 or more, a plurality of R^{A2}'s or a plurality of R^{A3}'s may be the same as or different from each other.

The divalent organic group represented by the general formula (A-3-1) represented by X^{A2} in the general formula (A-3) is as follows. 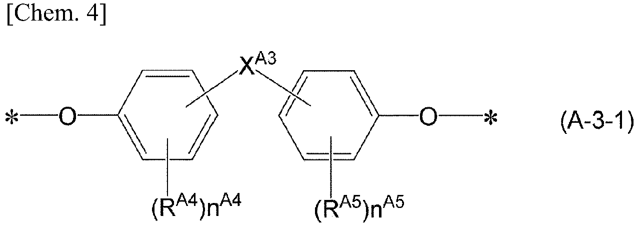 (In the formula, R^{A4} and R^{A5} are each independently an aliphatic hydrocarbon group having 1 to 5 carbon atoms or a halogen atom; X^{A3} is an alkylene group having 1 to 5 carbon atoms, an alkylidene group having 2 to 5 carbon atoms, an ether group, a sulfide group, a sulfonyl group, a carbonyloxy group, a keto group, or a single bond; n^{A4} and n^{A5} are each independently an integer of 0 to 4; and * represents a bonding site.)

Examples of the aliphatic hydrocarbon group having 1 to 5 carbon atoms and the halogen atom represented by R^{A4} and R^{A5} in the general formula (A-3-1) are the same as those described above for R^{A1}.

Examples of the alkylene group having 1 to 5 carbon atoms and the alkylidene group having 2 to 5 carbon atoms represented by X^{A3} in the general formula (A-3-1) are the same as those described above for X^{A2}.

n^{A4} and n^{A5} in the general formula (A-3-1) are each independently an integer of 0 to 4, and both of them are preferably an integer of 0 to 2, more preferably 0 or 1, and still more preferably 0.

When n^{A4} or n^{A5} is an integer of 2 or more, a plurality of R^{A4}'s or a plurality of R^{A5}'s may be the same as or different from each other. 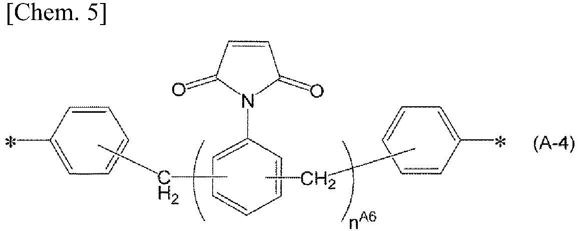 (In the formula, n^{A6} is an integer of 0 to 10; and * represents a bonding site.) 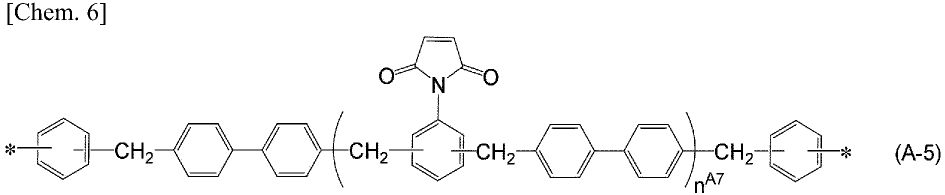 (In the formula, n^{A7} is a number of 0 to 5; and * represents a bonding site.) 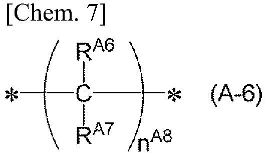 (In the formula, R^{A6} and R^{A7} are each independently a hydrogen atom or an aliphatic hydrocarbon group having 1 to 5 carbon atoms; n^{A8} is an integer of 1 to 8; and * represents a bonding site.)

Examples of the aliphatic hydrocarbon group having 1 to 5 carbon atoms and the halogen atom represented by R^{A6} and R^{A7} in the general formula (A-6) are the same as those described above for R^{A1}.

In the case where n^{A8} in the general formula (A-6) is an integer of 2 or more, a plurality of R^{A6}'s or a plurality of R^{A7}'s may be the same as or different from each other.

Examples of the maleimide resin (AX) include an aromatic bismaleimide resin, an aromatic polymaleimide resin, and an aliphatic maleimide resin.

Examples of the maleimide resin (AX) include bis(4-maleimidophenyl)methane, m-phenylenebismaleimide, 2,2-bis[4-(4-maleimidophenoxy)phenyl]propane, 4-methyl-1,3-phenylenebismaleimide, 3,3'-dimethyl-5,5'-diethyl-4,4'-diphenylmethanebismaleimide, polyphenylmethanemaleimide, a biphenyl aralkyl type maleimide, and an aromatic bismaleimide resin having an indane skeleton. Among these, 2,2-bis[4-(4-maleimidophenoxy)phenyl]propane is preferable.

### <<Structure Derived from Siloxane Diamine>>

Examples of the structure derived from a siloxane diamine include a structure formed by a Michael addition reaction between one or both of the two primary amino groups of the siloxane diamine and the N-substituted maleimide group of the maleimide resin (AX).

The structure derived from a siloxane diamine contained in the siloxane-modified maleimide resin (A) may be one kind alone, or may be two or more kinds.

The content of the structure derived from a siloxane diamine in the siloxane-modified maleimide resin (A) is preferably 5 to 95% by mass, more preferably 7 to 70% by mass, and still more preferably 10 to 40% by mass, from the viewpoint of low thermal expansion property.

### - Siloxane Diamine -

The siloxane diamine is not particularly limited as long as it is a siloxane compound having two primary amino groups.

The siloxane diamine preferably contains a divalent group having a structure represented by the following general formula (A-7). 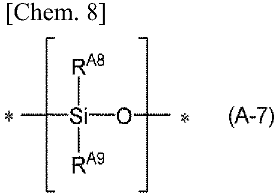 (In the formula, R^{A8} and R^{A9} are each independently an aliphatic hydrocarbon group having 1 to 5 carbon atoms, a phenyl group, or a substituted phenyl group; and * represents a bonding site.)

Examples of the aliphatic hydrocarbon group having 1 to 5 carbon atoms represented by R^{A8} and R^{A9} in the general formula (A-7) include an alkyl group having 1 to 5 carbon atoms such as a methyl group, an ethyl group, an n-propyl group, an isopropyl group, an n-butyl group, an isobutyl group, a t-butyl group, and an n-pentyl group; an alkenyl group having 2 to 5 carbon atoms; and an alkynyl group having 2 to 5 carbon atoms. The aliphatic hydrocarbon group having 1 to 5 carbon atoms may be either linear or branched. As the aliphatic hydrocarbon group having 1 to 5 carbon atoms, an aliphatic hydrocarbon group having 1 to 3 carbon atoms is preferable, an alkyl group having 1 to 3 carbon atoms is more preferable, and a methyl group is still more preferable.

Examples of the substituent of the phenyl group in the substituted phenyl group represented by R^{A8} and R^{A9} include the above-described aliphatic hydrocarbon group having 1 to 5 carbon atoms.

The siloxane diamine is preferably a silicone compound having a primary amino group at both terminals, and more preferably a compound represented by the following general formula (A-8). 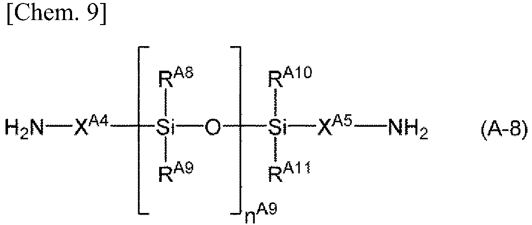 (In the formula, R^{A8} and R^{A9} are the same as those in the general formula (A-7); R^{A10} and R^{A11} are each independently an aliphatic hydrocarbon group having 1 to 5 carbon atoms, a phenyl group, or a substituted phenyl group; X^{A4} and X^{A5} are each independently a divalent organic group; and n^{A9} is an integer of 2 to 100.)

Examples of the aliphatic hydrocarbon group having 1 to 5 carbon atoms represented by R^{A10} and R^{A11} in the general formula (A-8) are the same as those described above for R^{A8} and R^{A9}.

Examples of the divalent organic group represented by X^{A4} and X^{A5} in the general formula (A-8) include an alkylene group, an alkenylene group, an alkynylene group, an arylene group, -O-, and a divalent linking group obtained by combining these groups.

Examples of the alkylene group include an alkylene group having 1 to 10 carbon atoms, such as a methylene group, an ethylene group, and a propylene group.

Examples of the alkenylene group include an alkenylene group having 2 to 10 carbon atoms.

Examples of the alkynylene group include an alkynylene group having 2 to 10 carbon atoms.

Examples of the arylene group include an arylene group having 6 to 20 carbon atoms, such as a phenylene group and a naphthylene group.

Among these, as X^{A4} and X^{A5}, an alkylene group and an arylene group are preferable, and an alkylene group is more preferable.

In the general formula (A-8), n^{A9} is an integer of 2 to 100, preferably an integer of 2 to 50, more preferably an integer of 3 to 40, and still more preferably an integer of 5 to 30. When n^{A9} is an integer of 2 or more, a plurality of R^{A8}'s or a plurality of R^{A9}'s may be the same as or different from each other.

The primary amino group equivalent of the siloxane diamine is preferably 300 to 2,000 g/mol, more preferably 400 to 1,500 g/mol, and still more preferably 500 to 1,000 g/mol.

### <<(A) Method for Producing Siloxane-Modified Maleimide Resin>>

The siloxane-modified maleimide resin (A) can be produced, for example, by subjecting the maleimide resin (AX) and a siloxane diamine to a Michael addition reaction in an organic solvent.

The reaction temperature of the Michael addition reaction is preferably 50 to 160°C, more preferably 60 to 150°C, and still more preferably 70 to 140°C, from the viewpoints of workability such as reaction rate, suppression of gelation of the product during the reaction, and the like.

The reaction time of the Michael addition reaction is preferably 0.5 to 10 hours, more preferably 1 to 6 hours, and still more preferably 1.5 to 4 hours, from the viewpoints of productivity and sufficient progress of the reaction.

When the maleimide resin (AX) is reacted with the siloxane diamine, a reaction catalyst may be used, if necessary.

However, these reaction conditions can be appropriately adjusted according to the types of raw materials used and the like, and are not particularly limited.

The weight-average molecular weight (Mw) of the siloxane-modified maleimide resin (A) is preferably 1,000 to 20,000, more preferably 3,000 to 15,000, and still more preferably 5,000 to 10,000, from the viewpoints of handleability and moldability.

The content of the siloxane-modified maleimide resin (A) in the resin composition is preferably 10 to 70% by mass, more preferably 20 to 60% by mass, and still more preferably 30 to 50% by mass with respect to the total amount (100% by mass) of the resin components in the resin composition.

When the content of the siloxane-modified maleimide resin (A) is within the above range, the heat resistance, the low thermal expansion property, the moldability, and the adhesiveness to a copper foil tend to be more easily improved.

Here, in the description herein, the "resin component" means a resin and a compound which forms a resin by a curing reaction. Examples of the resin component include the component (A), the component (B), the component (C), and the component (D). On the other hand, the component (E), the component (F), and the like are not included in the resin component.

The content of the resin component in the resin composition is preferably 5 to 70% by mass, more preferably 10 to 60% by mass, and still more preferably 20 to 40% by mass with respect to the total amount of solid content (100% by mass) of the resin composition.

When the content of the resin component is equal to or more than the lower limit value, the heat resistance, the moldability, the processability, and the adhesiveness to a copper foil tend to be more easily improved. On the other hand, when the content of the resin component is equal to or less than the upper limit value, the low thermal expansion property tends to be more easily improved.

### ((B) Maleimide Resin Other than Component (A))

The resin composition preferably further contains, as a component (B), a maleimide resin other than the component (A) [hereinafter sometimes referred to as "maleimide resin (B)"].

In the prepreg of the present embodiment, the heat resistance tends to be further improved by containing the maleimide resin (B) in the resin composition.

The maleimide resin (B) may be used alone or may be used in combination of two or more kinds thereof.

Examples of the maleimide resin (B) include the maleimide resin (AX) described above. Among these, a maleimide resin having three or more N-substituted maleimide groups is preferable, and a maleimide resin having three or more N-substituted maleimide groups bonded to an aromatic ring is more preferable.

The number of N-substituted maleimide groups of the maleimide resin having three or more N-substituted maleimide groups may be 6 or less, or may be 5 or less, from the viewpoint of handleability.

The maleimide resin (B) is preferably a compound represented by the following general formula (B-1). 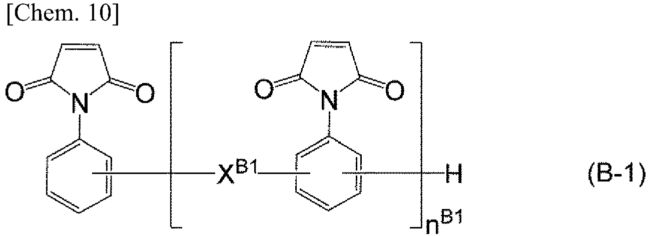 (In the formula, X^{B1}'s are each independently a divalent hydrocarbon group having 1 to 20 carbon atoms, and n^{B1} is an integer of 2 to 5.)

Examples of the divalent hydrocarbon group having 1 to 20 carbon atoms represented by X^{B1} in the general formula (B-1) include a divalent aliphatic hydrocarbon group such as an alkylene group having 1 to 5 carbon atoms and an alkylidene group having 2 to 5 carbon atoms; and a divalent hydrocarbon group including an aromatic hydrocarbon group represented by the following general formula (B-2).

Examples of the alkylene group having 1 to 5 carbon atoms include a methylene group, a 1,2-dimethylene group, a 1,3-trimethylene group, a 1,4-tetramethylene group, and a 1,5-pentamethylene group. The alkylene group having 1 to 5 carbon atoms is preferably an alkylene group having 1 to 3 carbon atoms, more preferably an alkylene group having 1 or 2 carbon atoms, and still more preferably a methylene group.

As the alkylidene group having 2 to 5 carbon atoms, an alkylidene group having 2 to 4 carbon atoms is preferable, an alkylidene group having 2 or 3 carbon atoms is more preferable, and an isopropylidene group is still more preferable. 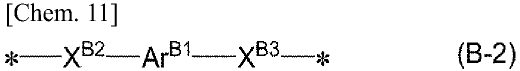 (In the formula, Ar^{B1} is a divalent aromatic hydrocarbon group, X^{B2} and X^{B3} are each independently a divalent aliphatic hydrocarbon group having 1 to 5 carbon atoms, and * represents a bonding site.)

Examples of the divalent aliphatic hydrocarbon group having 1 to 5 carbon atoms represented by X^{B2} and X^{B3} in the general formula (B-2) include the same groups as the alkylene group having 1 to 5 carbon atoms, the alkylidene group having 2 to 5 carbon atoms, and the like exemplified as X^{B1} in the general formula (B-1). Among these, a methylene group is preferable.

Examples of the divalent aromatic hydrocarbon group represented by Ar^{B1} in the general formula (B-2) include a phenylene group, a naphthylene group, a biphenylene group, and an anthranylene group. Among these, a biphenylene group is preferable. Examples of the biphenylene group include a 4,2'-biphenylene group, a 4,3'-biphenylene group, a 4,4'-biphenylene group, and a 3,3'-biphenylene group, and among these, a 4,4'-biphenylene group is preferable.

Among the above options, X^{B1} in the general formula (B-1) is preferably an alkylene group having 1 to 5 carbon atoms or an alkylidene group having 2 to 5 carbon atoms, more preferably a methylene group or an isopropylidene group, and still more preferably a methylene group.

n^{B1} in the general formula (B-1) is an integer of 2 to 5, preferably an integer of 2 to 4, and more preferably an integer of 2 or 3.

Examples of the compound represented by the general formula (B-1) include polyphenylmethanemaleimide and a biphenyl aralkyl type maleimide. Among these, polyphenylmethanemaleimide is preferable from the viewpoints of desmear resistance, heat resistance, low thermal expansion property, and elastic modulus.

In a case where the resin composition contains the maleimide resin (B), the content of the maleimide resin (B) is preferably 10 to 70% by mass, more preferably 20 to 60% by mass, and still more preferably 30 to 50% by mass, with respect to the total amount (100% by mass) of the resin components in the resin composition.

When the content of the maleimide resin (B) is equal to or more than the above lower limit value, the desmear resistance, the heat resistance, the low thermal expansion property, and the elastic modulus tend to be more easily improved. On the other hand, when the content of the maleimide resin (B) is equal to or less than the above upper limit value, the fluidity of the resin composition tends to be improved, and the moldability of the prepreg tends to be more easily improved.

### ((C) Epoxy Resin)

The resin composition preferably further contains (C) an epoxy resin.

In the prepreg of the present embodiment, the heat resistance tends to be further improved by containing the epoxy resin (C) in the resin composition.

The epoxy resin (C) may be used alone or may be used in combination of two or more kinds thereof.

The epoxy resin (C) is preferably an epoxy resin having two or more epoxy groups.

The epoxy resin (C) is classified into a glycidyl ether type epoxy resin, a glycidyl amine type epoxy resin, and a glycidyl ester type epoxy resin. Among these, a glycidyl ether type epoxy resin is preferable.

The epoxy resins (C) are also classified into various epoxy resins depending on the main backbone, and in each of the above types of epoxy resins, epoxy resins are further classified into bisphenol type epoxy resins such as bisphenol A type epoxy resin, bisphenol F type epoxy resin, and bisphenol S type epoxy resin; alicyclic epoxy resins such as dicyclopentadiene type epoxy resin; aliphatic linear epoxy resins; novolac type epoxy resins such as phenol novolac type epoxy resin, cresol novolac type epoxy resin, bisphenol A novolac type epoxy resin, bisphenol F novolac type epoxy resin, phenol aralkyl novolac type epoxy resin, and biphenyl aralkyl novolac type epoxy resin; stilbene type epoxy resins; naphthalene type epoxy resins such as naphthol novolac type epoxy resin and naphthol aralkyl type epoxy resin; biphenyl type epoxy resins; xylylene type epoxy resins; and dihydroanthracene type epoxy resins. Among these, a naphthalene type epoxy resin is preferable from the viewpoints of heat resistance and low thermal expansion property.

In a case where the resin composition contains the epoxy resin (C), the content of the epoxy resin (C) is preferably 1 to 30% by mass, more preferably 2 to 20% by mass, and still more preferably 3 to 10% by mass with respect to the total amount (100% by mass) of the resin components in the resin composition.

When the content of the epoxy resin (C) is equal to or more than the above lower limit value, the heat resistance tends to be more easily improved. On the other hand, when the content of the epoxy resin (C) is equal to or less than the above upper limit value, the low thermal expansion property tends to be more easily improved.

### ((D) Benzoxazine Resin)

The resin composition preferably further contains (D) a benzoxazine resin.

When the resin composition contains the benzoxazine resin (D), the prepreg of the present embodiment tends to have excellent toughness of the cured product.

The "benzoxazine resin" in the present embodiment means a resin having at least one or more benzoxazine rings in the molecule. In addition, the "benzoxazine ring" in the present embodiment means a ring structure in which one of two double bonds contained in an oxazine ring having a six-membered ring structure containing one oxygen atom and one nitrogen atom is dihydrogenated, and the other double bond is fused to a benzene ring.

The benzoxazine resin (D) may be used alone or may be used in combination of two or more kinds thereof.

The benzoxazine resin (D) is only required to have one or more benzoxazine rings, preferably has two or three benzoxazine rings, and more preferably has two benzoxazine rings.

As the benzoxazine resin (D), a known benzoxazine resin can be used, and examples thereof include P-d type benzoxazine, F-a type benzoxazine, ALP-d type benzoxazine, and T-ala type benzoxazine.

Examples of the benzoxazine resin (D) include a compound represented by the following general formula (D-1) and a compound represented by the following general formula (D-2). 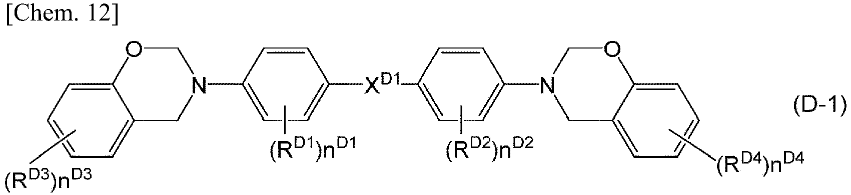 (In the formula, R^{D1}, R^{D2}, R^{D3}, and R^{D4} are each independently a hydrocarbon group having 1 to 10 carbon atoms; X^{D1} is an alkylene group having 1 to 5 carbon atoms, an alkylidene group having 2 to 5 carbon atoms, -O-, a sulfonyl group, a carbonyloxy group, -C(=O)-, or a single bond; and n^{D1}, n^{D2}, n^{D3}, and n^{D4} are each independently an integer of 0 to 4.) 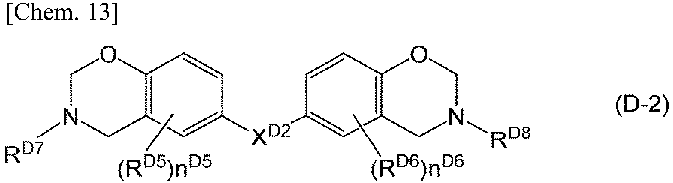 (In the formula, R^{D5} and R^{D6} are each independently a hydrocarbon group having 1 to 10 carbon atoms; R^{D7} and R^{D8} are each independently a hydrocarbon group having 1 to 10 carbon atoms or a hydrogen atom; X^{D2} is an alkylene group having 1 to 5 carbon atoms, an alkylidene group having 2 to 5 carbon atoms, -O-, a sulfonyl group, a carbonyloxy group, - C(=O)-, or a single bond; and n^{D5} and n^{D6} are each an integer of 0 to 3.)

Examples of the hydrocarbon group having 1 to 10 carbon atoms represented by R^{D1}, R^{D2}, R^{D3}, and R^{D4} in the general formula (D-1) include an aliphatic hydrocarbon group such as a methyl group, an ethyl group, an n-propyl group, an isopropyl group, an n-butyl group, an isobutyl group, a t-butyl group, an n-pentyl group, an n-octyl group, and an n-decyl group; and an aromatic hydrocarbon group such as a phenyl group.

In the general formula (D-1), n^{D1}, n^{D2}, n^{D3}, and n^{D4} are each independently an integer of 0 to 4, and from the viewpoint of availability, an integer of 0 to 2 is preferable, and 0 is more preferable.

Examples of the alkylene group having 1 to 5 carbon atoms represented by X^{D1} in the general formula (D-1) include a methylene group, a 1,2-dimethylene group, a 1,3-trimethylene group, a 1,4-tetramethylene group, and a 1,5-pentamethylene group. The alkylene group is preferably an alkylene group having 1 to 3 carbon atoms, and more preferably a methylene group.

Examples of the alkylidene group having 2 to 5 carbon atoms represented by X^{D1} in the general formula (D-1) include an ethylidene group, a propylidene group, an isopropylidene group, a butylidene group, an isobutylidene group, a pentylidene group, and an isopentylidene group. Among these, an isopropylidene group is preferable.

In the general formula (D-2), examples of the hydrocarbon group having 1 to 10 carbon atoms represented by R^{D5} and R^{D6} are the same as those described above for R^{D1}.

In the general formula (D-2), n^{D5} and n^{D6} are each independently an integer of 0 to 3, and from the viewpoint of availability, an integer of 0 to 2 is preferable, and 0 is more preferable.

In the general formula (D-2), examples of the alkylene group having 1 to 5 carbon atoms and the alkylidene group having 2 to 5 carbon atoms represented by X^{D2} are the same as those described above for X^{D1}.

In the general formula (D-2), examples of the hydrocarbon group having 1 to 10 carbon atoms represented by R^{D7} and R^{D8} are the same as those described above for R^{D5} and R^{D6}. Among these, R^{D7} and R^{D8} are preferably an aromatic hydrocarbon group and more preferably a phenyl group.

Among the compounds represented by the general formula (D-1) or (D-2), the compound represented by the general formula (D-1) is preferable from the viewpoints of low thermal expansion property and heat resistance.

In a case where the resin composition contains the benzoxazine resin (D), the content of the benzoxazine resin (D) is preferably 1 to 30% by mass, more preferably 5 to 25% by mass, and still more preferably 10 to 20% by mass with respect to the total amount (100% by mass) of the resin components in the resin composition.

When the content of the benzoxazine resin (D) is equal to or more than the above lower limit value, the toughness tends to be more easily improved. On the other hand, when the content of the benzoxazine resin (D) is equal to or less than the above upper limit value, the heat resistance tends to be more easily improved.

### ((E) Inorganic Filler)

The resin composition preferably further contains (E) an inorganic filler.

In the prepreg of the present embodiment, when the resin composition contains the inorganic filler (E), more excellent low thermal expansion property and heat resistance tend to be easily obtained.

The inorganic filler (E) may be used alone or may be used in combination of two or more kinds thereof.

Examples of the inorganic filler (E) include silica, alumina, titanium oxide, mica, beryllia, barium titanate, potassium titanate, strontium titanate, calcium titanate, aluminum carbonate, magnesium hydroxide, aluminum hydroxide, aluminum silicate, calcium carbonate, calcium silicate, magnesium silicate, silicon nitride, boron nitride, clay, talc, aluminum borate, and silicon carbide. Among these, from the viewpoints of low thermal expansion property, heat resistance, and flame retardancy, silica, alumina, mica, and talc are preferable, silica and alumina are more preferable, and silica is still more preferable.

The silica is preferably fused silica from the viewpoints of dispersibility and moldability.

The average particle diameter (D₅₀) of the inorganic filler (E) is preferably 0.1 to 10 µm, more preferably 0.2 to 1 µm, and still more preferably 0.3 to 0.8 µm, from the viewpoints of dispersibility and fine wiring properties.

The average particle diameter (D₅₀) of the inorganic filler (E) in the description herein is a particle diameter at a point corresponding to 50% by volume when a cumulative frequency distribution curve based on the particle diameter is obtained with the total volume of the particles as 100%. The average particle diameter of the inorganic filler (E) can be measured by, for example, a particle size distribution analyzer using a laser diffraction scattering method.

Examples of the shape of the inorganic filler (E) include a spherical shape and a crushed shape, and a spherical shape is preferable.

The inorganic filler (E) may be surface-treated with, for example, a surface treatment agent such as a silane coupling agent from the viewpoint of improving the dispersibility and the adhesion to the organic component.

In a case where the resin composition contains the inorganic filler (E), the content of the inorganic filler (E) is preferably 30 to 90% by mass, more preferably 40 to 85% by mass, and still more preferably 60 to 80% by mass, with respect to the total amount of solid content (100% by mass) of the resin composition.

When the content of the inorganic filler (E) is equal to or more than the above lower limit value, the low thermal expansion property and the heat resistance tend to be more easily improved. On the other hand, when the content of the inorganic filler (E) is equal to or less than the above upper limit value, the moldability and the adhesiveness to a copper foil tend to be more easily improved.

### ((F) Curing Accelerator)

The resin composition preferably further contains (F) a curing accelerator.

By containing the curing accelerator (F), the resin composition tends to have an improved curability and easily obtain more excellent adhesiveness to a copper foil.

The curing accelerator (F) may be used alone or may be used in combination of two or more kinds thereof.

Examples of the curing accelerator (F) include acidic catalysts such as p-toluenesulfonic acid; amine compounds such as triethylamine, tributylamine, pyridine, and dicyandiamide; imidazole compounds such as methylimidazole, phenylimidazole, 1-cyanoethyl-2-phenylimidazole, and 1-cyanoethyl-2-phenylimidazolium trimellitate; isocyanate-masked imidazole compounds such as an addition reaction product of hexamethylene diisocyanate resin and 2-ethyl-4-methylimidazole; quaternary ammonium compounds; phosphorus-based compounds such as triphenylphosphine; organic peroxides such as dicumyl peroxide, 2,5-dimethyl-2,5-bis(t-butylperoxy)hexyne-3,2,5-dimethyl-2,5-bis(t-butylperoxy)hexane, t-butylperoxyisopropyl monocarbonate, and α,α'-bis(t-butylperoxy)diisopropylbenzene; and carboxylates of manganese, cobalt, and zinc.

Among these, an isocyanate-masked imidazole compound is preferable from the viewpoints of curing accelerating effect and storage stability.

In a case where the resin composition contains the curing accelerator (F), the content of the curing accelerator (F) is preferably 0.01 to 10 parts by mass, more preferably 0.05 to 5 parts by mass, and still more preferably 0.1 to 1 part by mass, with respect to 100 parts by mass of the total amount of the resin components in the resin composition.

When the content of the curing accelerator (F) is equal to or more than the above lower limit value, sufficient curing acceleration effect tends to be easily obtained. On the other hand, when the content of the curing accelerator (F) is equal to or less than the above upper limit value, storage stability tends to be more easily improved.

### (Other Optional Components)

The resin composition may further contain, if necessary, one or more other optional components selected from the group consisting of a resin material other than the above-mentioned components, an antioxidant, a thermal stabilizer, an antistatic agent, an ultraviolet absorber, a pigment, a colorant, a lubricant, an organic solvent, and additives other than these.

For each of the above optional components, one kind may be used alone, or two or more kinds may be used in combination.

The contents of the optional components in the resin composition are not particularly limited, and the optional components may be used as necessary within a range that does not impair the effects of the present embodiment. In addition, the resin composition may not contain the above-mentioned optional components depending on the desired performance.

### (Organic Solvent)

From the viewpoint of handleability, the resin composition may be a varnish-like resin composition containing an organic solvent.

Examples of the organic solvent include alcohol-based solvents such as ethanol, propanol, butanol, methyl cellosolve, butyl cellosolve, and propylene glycol monomethyl ether; ketone-based solvents such as acetone, methyl ethyl ketone, methyl isobutyl ketone, and cyclohexanone; ether-based solvents such as tetrahydrofuran; aromatic hydrocarbon-based solvents such as toluene, xylene, and mesitylene; nitrogen atom-containing solvents such as dimethylformamide, dimethylacetamide, and N-methylpyrrolidone; sulfur atom-containing solvents such as dimethyl sulfoxide; and ester-based solvents such as γ-butyrolactone.

### (Method for Producing Resin Composition)

The resin composition can be produced by mixing the respective components. In this case, the respective components may be dissolved or dispersed while stirring. Conditions such as a mixing order, a temperature, and a time are not particularly limited, and may be arbitrarily set according to the type of raw material.

### <Fiber Substrate>

The fiber substrate contained in the prepreg of the present embodiment contains glass fibers having an Al₂O₃ content of 20% by mass or more.

When the fiber substrate contains glass fibers having an Al₂O₃ content of 20% by mass or more, the cured product of the prepreg of the present embodiment has excellent wettability to water.

The content of Al₂O₃ in the glass fibers is 20% by mass or more, preferably 21 to 35% by mass, more preferably 22 to 30% by mass, and still more preferably 23 to 27% by mass, from the viewpoint of wettability to water.

The content of Al₂O₃ derived from glass fibers in the prepreg of the present embodiment is preferably 9 to 50% by mass, more preferably 10 to 40% by mass, still more preferably 11 to 30% by mass, and yet still more preferably 12 to 20% by mass from the viewpoint of wettability to water.

The content of Al₂O₃ in the total amount (100% by mass) of the inorganic components contained in the prepreg of the present embodiment is preferably 10 to 55% by mass, more preferably 11 to 45% by mass, still more preferably 12 to 35% by mass, and yet still more preferably 13 to 25% by mass from the viewpoint of wettability to water.

The glass fibers preferably further contain SiO₂.

The content of SiO₂ in the glass fibers is preferably 50 to 80% by mass, more preferably 55 to 75% by mass, and still more preferably 60 to 70% by mass from the viewpoint of wettability to water.

When the glass fibers further contain SiO₂, the total content of Al₂O₃ and SiO₂ in the glass fibers is preferably 70% by mass or more, more preferably 80% by mass or more, and still more preferably 85% by mass or more from the viewpoint of wettability to water. On the other hand, the total content of Al₂O₃ and SiO₂ in the glass fibers is preferably 96% by mass or less, more preferably 95% by mass or less, and still more preferably 94% by mass or less.

The glass fibers may contain, in addition to SiO₂ and Al₂O₃, other components such as Fe₂O₃, B₂O₃, CaO, MgO, Na₂O, K₂O, Li₂O, TiO₂, ZnO, ZrO₂, and F₂. The components other than SiO₂ and Al₂O₃ contained in the glass fibers are preferably one or more of the other components described above.

Among these, the glass fibers preferably further contain MgO.

The content of MgO in the glass fibers is preferably 2 to 20% by mass, more preferably 5 to 15% by mass, and still more preferably 7 to 12% by mass.

Preferred examples of the glass fibers include T-glass and S-glass.

The fiber substrate may have a shape of, for example, a woven fabric, a nonwoven fabric, a roving, a chopped strand mat, or a surfacing mat, and is preferably a glass cloth.

The fiber substrate may be surface-treated with a coupling agent or may be subjected to a mechanical opening treatment from the viewpoints of the impregnation property of the resin composition and the like.

The thickness of the fiber substrate is preferably 5 to 200 µm, more preferably 20 to 150 µm, still more preferably 50 to 110 µm, and yet still more preferably 70 to 100 µm from the viewpoints of mechanical strength of the prepreg and high density wiring.

The basis weight of the fiber substrate is preferably 10 to 210 g/m², more preferably 50 to 180 g/m², and still more preferably 100 to 130 g/m², from the viewpoints of mechanical strength of the prepreg and high density wiring.

### <Method for Producing Prepreg>

The prepreg of the present embodiment can be produced by, for example, impregnating or coating the resin composition into a fiber substrate and then heating and drying the impregnated or coated resin composition to make it B-stage.

The temperature and time of the heating and drying may be, for example, set to 50 to 200°C and 1 to 30 minutes from the viewpoints of productivity and appropriately bringing the resin composition of the present embodiment into the B-stage.

### <Content of Resin Composition>

The content of the resin composition in the prepreg of the present embodiment is preferably 30 to 90% by mass, more preferably 35 to 70% by mass, and still more preferably 40 to 60% by mass from the viewpoint of moldability.

### <Content of Inorganic Component>

The content of the inorganic component contained in the prepreg of the present embodiment is preferably 50 to 97% by mass, more preferably 60 to 95% by mass, still more preferably 70 to 93% by mass, and yet still more preferably 80 to 90% by mass from the viewpoint of wettability to water.

### <Thickness of Prepreg>

The thickness of the prepreg of the present embodiment is preferably 5 to 200 µm, more preferably 20 to 150 µm, and still more preferably 50 to 110 µm from the viewpoints of mechanical strength of the prepreg and high density wiring.

### [Laminated Plate]

The laminated plate of the present embodiment is a laminated plate having a cured product of the prepreg of the present embodiment and a metal foil.

Examples of the metal of the metal foil include copper, gold, silver, nickel, platinum, molybdenum, ruthenium, aluminum, tungsten, iron, titanium, chromium, and an alloy containing one or more kinds of these metal elements.

The laminated plate of the present embodiment can be produced, for example, by disposing a metal foil on one surface or both surfaces of the prepreg of the present embodiment, and then subjecting the prepreg to heating and press molding.

Usually, the B-staged prepreg is cured by this heating and press molding to obtain the laminated plate of the present embodiment.

When the heating and press molding is performed, only one sheet of prepreg may be used, or two or more sheets of prepreg may be laminated and used. The number of prepregs to be laminated may be, for example, 2 to 20 sheets, 4 to 18 sheets, or 6 to 16 sheets.

For the heating and press molding, for example, a multi-stage press, a multi-stage vacuum press, a continuous molding, or an autoclave molding machine can be used.

As the conditions of the heating and press molding, the temperature may be 100 to 300°C, the time may be 10 to 300 minutes, and the pressure may be 1.5 to 5 MPa, for example.

### [Printed Wiring Board and Method for Producing Same]

The printed wiring board of the present embodiment is a printed wiring board having a cured product of the prepreg of the present embodiment.

The printed wiring board of the present embodiment can be produced by, for example, forming a conductor circuit on the cured product of the prepreg of the present embodiment by a known method.

The method for producing a printed wiring board of the present embodiment is a method for producing a printed wiring board, including forming a through hole in a cured product of the prepreg of the present embodiment, and then forming a conductor layer in the through hole by a plating method.

The cured product of the prepreg in which the through hole is formed may be the laminated plate of the present embodiment described above, or may be a cured product obtained by laminating the prepreg of the present embodiment on one surface or both surfaces of a circuit board and curing the prepreg.

The through hole may be formed by a known method, and can be formed by, for example, a method of forming the through hole using a drill, a laser, or plasma, or a method of combining these. Examples of the laser used for forming the through hole include a carbon dioxide laser, a YAG laser, a UV laser, and an excimer laser.

The shape of the through hole in a plan view is not particularly limited, but is preferably a circular shape.

The through hole having a circular shape may have a diameter of 300 µm or less, 200 µm or less, or 150 µm or less. Since the cured product of the prepreg of the present embodiment has excellent wettability to water, the plating liquid easily flows into the through hole even when the diameter of the through hole is small, and good plating property in the through hole can be obtained.

Further, the diameter of the through hole having a circular shape may be 40 µm or more, may be 100 µm or more, or may be 150 µm or more as desired.

In addition, the "circular shape" of the present embodiment is a concept including an ellipse in addition to a perfect circle, and in the case of an ellipse, the major axis of the ellipse is defined as the diameter.

Subsequently, the surface of the cured product of the prepreg may be subjected to a roughening treatment with an oxidizing agent. In addition, a so-called "smear" generated at the time of forming the through hole may be removed simultaneously with the roughening treatment.

Next, a conductor layer is formed by a plating method on the surface of the cured product of the prepreg subjected to the roughening treatment and in the through hole.

Examples of the plating method include an electroless plating method and an electrolytic plating method. Examples of the metal for plating include copper, gold, silver, nickel, platinum, molybdenum, ruthenium, aluminum, tungsten, iron, titanium, chromium, and alloys containing at least one of these metal elements. Among these, copper and nickel are preferable, and copper is more preferable.

Thereafter, as a method of patterning the conductor layer to form a circuit, for example, a known method such as a subtractive method, a full-additive method, a semi-additive method (SAP: Semi Additive Process), or a modified semi-additive method (m-SAP: modified Semi Additive Process) can be used.

Further, a multilayer printed wiring board can be produced by appropriately repeating necessary steps.

### [Semiconductor Package]

The semiconductor package of the present embodiment is a semiconductor package including the printed wiring board of the present embodiment and a semiconductor element.

The semiconductor package of the present embodiment can be produced, for example, by mounting a semiconductor chip and a memory on the printed wiring board of the present embodiment by a known method.

### Examples

Hereinafter, the present embodiment will be specifically described with reference to Examples. However, the present embodiment is not limited to the following Examples.

In each example, weight-average molecular weight (Mw) was measured by the following method.

It was converted from a calibration curve using standard polystyrene by gel permeation chromatography (GPC). The calibration curve was approximated by a cubic equation using standard polystyrene: TSK standard POLYSTYRENE (Type; A-2500, A-5000, F-1, F-2, F-4, F-10, F-20, F-40) (manufactured by Tosoh Corporation, trade name). The measurement conditions of GPC are shown below.

### Device:

Pump: L-6200 type (manufactured by Hitachi High-Tech Corporation)
Detector: L-3300 type RI (manufactured by Hitachi High-Tech Corporation)
Column oven: L-655A-52 (manufactured by Hitachi High-Tech Corporation)
Column: Guard column; TSK Guardcolumn HHR-L + column; TSKgel G4000HHR + TSKgel G2000HHR (all manufactured by Tosoh Corporation, trade name)
Column size: 6.0 × 40 mm (guard column), 7.8 × 300 mm (column)
Eluent: tetrahydrofuran
Sample concentration: 30 mg/5 mL
Injection volume: 20 µL
Flow rate: 1.00 mL/min
Measurement temperature: 40°C

### Production Example 1: Production of siloxane-modified maleimide resin

50 g of a silicone compound having a primary amino group at both terminals (trade name: XF42-C5379, manufactured by Momentive Performance Materials Japan LLC, functional group equivalent of primary amino group: 740 g/mol), 100 g of 2,2-bis[4-(4-maleimidophenoxy)phenyl]propane, and 200 g of propylene glycol monomethyl ether were placed in a reaction vessel having a volume of 2 L capable of heating and cooling and equipped with a thermometer, a stirring device, and a moisture determination device with a reflux cooling pipe, and then reacted at 120°C for 2 hours to produce a siloxane-modified maleimide resin. The weight-average molecular weight (Mw) of the obtained siloxane-modified maleimide resin was 8,000.

### Example 1 and Comparative Example 1

### (Production of Resin Composition)

Each of the components listed in Table 1 was stirred and mixed with methyl isobutyl ketone to prepare a varnish-like resin composition having a solid content concentration of 55 to 65% by mass. In Table 1, the unit of the blending amount of each component is parts by mass, and in the case of a solution, the unit means parts by mass in terms of solid content.

### (Production of Prepreg)

A fiber substrate shown in Table 1 was impregnated with the varnish-like resin composition obtained above, and heated and dried at 130°C for 5 minutes to obtain a prepreg. The content of the resin composition in the prepreg was 50% by mass.

### (Production of Copper-Clad Laminated Plate)

Eight sheets of the prepreg obtained above were stacked, and a copper foil having a thickness of 12 µm (manufactured by Mitsui Mining & Smelting Co., Ltd., trade name "3EC-M3-VLP-12", Rz of the roughened surface: 3.0 µm) was disposed on the upper and lower sides thereof so that the roughened surface was in contact with the prepreg. This laminate was subjected to heating and press molding for 80 minutes under the conditions of a temperature of 240°C and a pressure of 3.0 MPa to obtain a copper-clad laminated plate.

### [Evaluation Methods]

Each evaluation was carried out according to the following methods. The results are shown in Table 1.

### (Method for Measuring Water Contact Angle)

The copper foils on both surfaces of the copper-clad laminated plate obtained in each example were removed by etching to obtain a laminated plate after an etching treatment.

In addition, the laminated plate after the etching treatment was immersed in a swelling liquid (manufactured by Atotech Japan K.K., trade name "Swelling Dip Securiganth P") heated to 80°C for 5 minutes. Next, the laminated plate was immersed in a roughening liquid (manufactured by Atotech Japan K.K., trade name "Concentrate Compact CP") heated to 80°C for 10 minutes. Subsequently, the laminated plate was neutralized by immersion in a neutralizing liquid (manufactured by Atotech Japan K.K., trade name "Reduction solution Securiganth P500") heated to 40°C for 5 minutes to obtain a laminated plate after a desmearing treatment.

The static contact angle when purified water was dropped on the surface of each of the laminated plate after the etching treatment and the laminated plate after the desmearing treatment as a measurement target was measured under the following conditions.
- Measuring apparatus: manufactured by NiCK Corporation, product name "LSE-B100TW"
- Measurement temperature: 25°C
- Amount of droplet of purified water: 1 µL (syringe size 25G)
- Image analysis method: θ/2 method
- Measurement time: 5 seconds after dropping

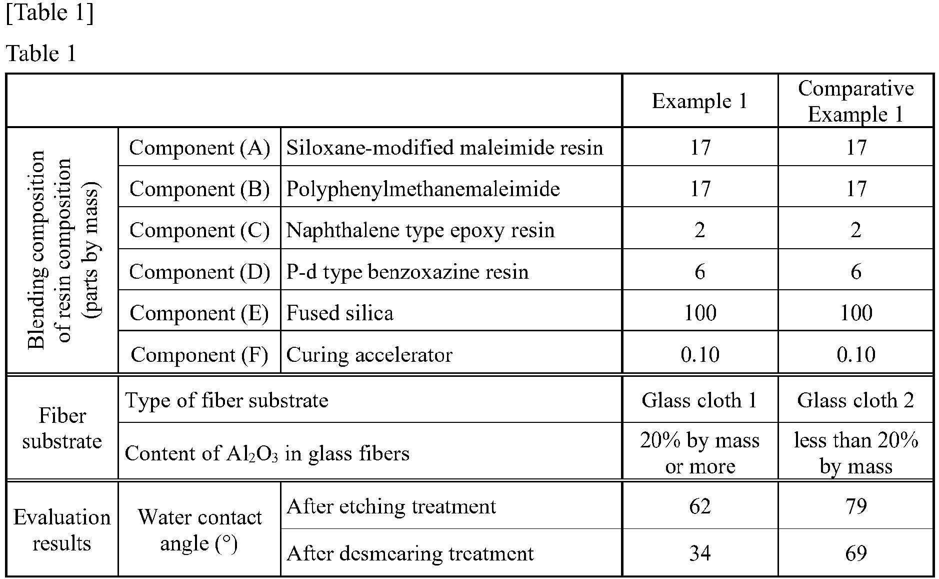

The details of each component and the fiber substrate shown in Table 1 are as follows.

### [Component (A)]

- Siloxane-modified maleimide resin: Siloxane-modified maleimide resin produced in Production Example 1

### [Component (B)]

- Polyphenylmethanemaleimide: manufactured by Daiwakasei Industry Co., Ltd., trade name "BMI-2300"

### [Component (C)]

- Naphthalene type epoxy resin: manufactured by DIC Corporation, trade name "HP-9540"

### [Component (D)]

- p-d type benzoxazine resin: Compound represented by the following formula

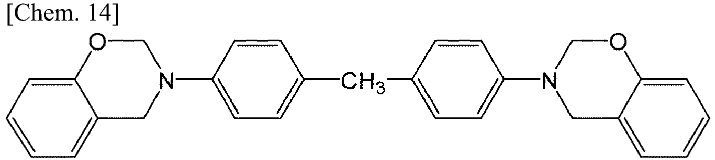

### [Component (E)]

- Fused silica: Average particle diameter (D₅₀) 0.5 µm, spherical fused silica

### [Component (F)]

- Curing accelerator: isocyanate-masked imidazole, trade name "G-8009L", manufactured by DKS Co., Ltd.

### [Fiber Substrate]

- Glass cloth 1: Basis weight: 110 g/m², Thickness of glass cloth: 90 µm, Composition of glass fibers (Al₂O₃ content: 24 to 26% by mass, SiO₂ content: 64 to 66% by mass, MgO content: 9 to 11% by mass)
- Glass cloth 2: Basis weight: 100 g/m², Thickness of glass cloth: 90 µm, Composition of glass fibers (Al₂O₃ content: 12 to 16% by mass, SiO₂ content: 52 to 56% by mass, CaO and MgO content: 20 to 25% by mass, Ba₂O₃ content: 5 to 10% by mass)

From Table 1, it can be seen that the cured product of the prepreg of Example 1 of the present embodiment has a small water contact angle and excellent wettability to water.

## Claims

1. A prepreg comprising: a resin composition containing a siloxane-modified maleimide resin; and a fiber substrate containing glass fibers having an Al₂O₃ content of 20% by mass or more.

2. The prepreg according to claim 1, wherein the siloxane-modified maleimide resin has a structure derived from a maleimide resin having one or more N-substituted maleimide groups and a structure derived from a siloxane compound having two primary amino groups.

3. The prepreg according to claim 1 or 2, wherein the glass fibers further contain SiO₂, and a total content of the Al₂O₃ and the SiO₂ in the glass fibers is 70% by mass or more.

4. The prepreg according to claim 1 or 2, wherein a content of the resin composition in the prepreg is 30 to 90% by mass.

5. A laminated plate comprising a cured product of the prepreg according to claim 1 or 2, and a metal foil.

6. A printed wiring board comprising a cured product of the prepreg according to claim 1 or 2.

7. A semiconductor package comprising the printed wiring board according to claim 6, and a semiconductor element.

8. A method for producing a printed wiring board, comprising forming a through hole in a cured product of the prepreg according to claim 1 or 2, and then forming a conductor layer in the through hole by a plating method.
